# EUROPEAN PATENT SPECIFICATION

(11) **EP 2 046 888 B1**
(45) Date of publication and mention of the grant of the patent: **21.02.2018**
(21) Application number: 07799863.1
(22) Date of filing: 27.07.2007
(51) Int. Cl.: H01L 31/048, C08L 27/12, G09F 3/00

(54) **PHOTOVOLTAIC MODULES HAVING A POLYVINYLIDENE FLUORIDE SURFACE**
PV-MODULE MIT POLYVINYLIDENFLUORIDOBERFLÄCHE
MODULES PHOTOVOLTAÏQUES COMPORTANT UNE SURFACE EN FLUORURE DE POLYVINYLIDÈNE

(30) Priority: 04.08.2006 US 835855 P
(43) Date of publication of application: 15.04.2009
(73) Proprietor: ARKEMA FRANCE, 92700 Colombes (FR)
(72) Inventor: BURCHILL, Michael T., Langhorne, Pennsylvania 19047 (US)
(74) Representative: Bonnel, Claudine
(86) International application number: PCT/US2007/074538
(87) International publication number: WO 2008/019229

(56) References cited:
- EP-A1- 1 382 640
- EP-A2- 0 877 050
- EP-A2- 0 877 427
- WO-A1-99/03900
- US-A- 5 718 772
- US-A1- 2005 136 205
- US-A1- 2005 187 354
- US-A1- 2006 057 392
- US-A1- 2006 057 392
- US-B1- 6 553 729

## Description

### Field of the Invention

The invention relates to a photovoltaic module for capturing and using solar radiation having as a transparent glazing a thermoplastic structural component covered by a thin layer of polyvinylidene fluoride. The polyvinylidene fluoride layer is exposed to the environment and provides a chemical resistant and dirt shedding surface. The structure may contain a tie layer between the polyvinylidene fluoride layer and the structural thermoplastic to aid in adhesion.

### Background of the Invention

Photovoltaic modules in field-use suffer from performance loss over time due to dirt build up on the primary surface. This is an extreme problem for solar panels near highways, where grime builds up quickly from a mixture of dirt, automobile exhaust soot and graphite/rubber particles from tires. The problem is even more severe in areas receiving little rainfall. Photovoltaic modules are much more prone to this problem than typical vertical signs, as the photovoltaic modules are generally tilted toward the horizontal to maximize solar exposure. Fouling of the photovoltaic module's surface reduces the amount of radiation reaching a photovoltaic modules, and can lead to reduction and even failure to charge batteries used to power signes. Such failure to fully charge batteries can be a safty issue, when the solar collector is used to power a warning ir information sign. In order to return the solar panel to optimal performance the solar panel must be washed. Washing can be needed as often as once a week. However, such frequent washing can lead to long-term performance degradation as the panels are scratched and marred in the washing steps.

While glass is sometimes used for a glazing on a solar collection device, thermoplastic are often used due to thier increased impact resistance and lower weight.

Polyvinylidene fluoride (PVDF) is known to be highly chemical resistant, relatively inert, and having a very low surface energy that little can stick to. The low surface energy means that PVDF materials readily can shed dirt.and grime.

Dirt shedding surface coatings containing fluoropolymers and organosilicates have been shown to provide a hydorphilic surface which easily sheds dirt as described in US 7,037,966. Using a thermoplastic coating on a photovoltaic module with an outer layer comprising PVDF is known from EP 0 877 427 A2, US 5,718,772 A, and US 2006/057392 A1. It it now proposed to solve the problem of grime build-up on solar collection devices having a thermoplastic glazing by adding a thin coating of PVDF to the exposed surface of the thermoplastic glazing.

### Summary of the invention

The invention relates to a photovoltaic module, comprising a transparent glazing material comprising a rigid thermoplastic support layer as defined in claim 1; and a polyvinylidene fluoride (PVDF) outer layer exposed to the environment; and attached directly or indirectly to said rigid thermoplastic layer. The photovoltaic module glazing may incorporate a tie or adhesive layer between the PVDF layer and rigid thermoplastic.

### Detailed description of the Invention

The invention relates to solar collection devices having a transparent thermoplastic glazing with a thin polyvinylidene fluoride coating layer on its surface.

By "photovoltaic modules", as used herein is meant a construction of photovoltaic cell circuits sealed in an environmentally protective laminate. Photovoltaic modules may be combined to form photovoltaic panels that are pre-wired, field-installable units. A photovoltaic array is the complete power-generating unit, consisting of any number of PV modules and panels.

### PVDF Layer

The outermost surface of the solar collection device is a thin polyvinylidene fluoride (PVDF) layer. The layer is from 3 to 100 microns thick, and preferably from 15 to 50 microns in thickness if added as a film or extrudable layer. A PVDF layer formed by a coating could be in the range of from 3 to 20 microns.

The PVDF layer of the invention may be a homopolymer made by polymerizing vinylidene fluoride (VDF), copolymers, terpolymers and higher polymers of vinylidene fluoride where the vinylidene fluoride units comprise greater than 70 percent of the total weight of all the monomer units in the polymer, and more preferably, comprise greater than 75 percent of the total weight of the units. Copolymers, terpolymers and higher polymers of vinylidene fluoride may be made by reacting vinylidene fluoride with one or more monomers from the group consisting of vinyl fluoride, trifluoroethene, tetrafluoroethene, one or more of partly or fully fluorinated alpha-olefins such as 3,3,3-trifluoro-1-propene, 1,2,3,3,3-pentafluoropropene, 3,3,3,4,4-pentafluoro-1-butene, and hexafluoropropene, the partly fluorinated olefin hexafluoroisobutylene, perfluorinated vinyl ethers, such as perfluoromethyl vinyl ether, perfluoroethyl vinyl ether, perfluoro-n-propyl vinyl ether, and perfluoro-2-propoxypropyl vinyl ether, fluorinated dioxoles, such as perfluoro(1,3-dioxole) and perfluoro(2,2-dimethyl-1,3-dioxole), allylic, partly fluorinated allylic, or fluorinated allylic monomers, such as 2-hydroxyethyl allyl ether or 3-allyloxypropanediol, and ethene or propene. Preferred copolymers or terpolymers are formed with vinyl fluoride, trifluoroethene, tetrafluoroethene (TFE), and hexafluoropropene (HFP).

Especially preferred copolymers are of VDF comprising from about 71 to about 99 weight percent VDF, and correspondingly from about 1 to about 29 percent TFE; from about 71 to 99 weight percent VDF, and correspondingly from about 1 to 29 percent HFP (such as disclosed in U.S. Pat. No. 3,178,399); and from about 71 to 99 weight percent VDF, and correspondingly from about 1 to 29 weight percent trifluoroethylene.

Especially preferred thermoplastic terpolymers are the terpolymer of VDF, HFP and TFE, and the terpolymer of VDF, trifluoroethene, and TFE, The especially preferred terpolymers have at least 71 weight percent VDF, and the other comonomers may be present in varying portions, but together they comprise up to 29 weight percent of the terpolymer.

The outer layer preferably is only the PVDF homo- or co-polymer, but it could also be a blend of PVDF with polymethyl methacrylate (PMMA), where the PVDF makes up greater that 50 volume percent. PVDF and PMMA can be melt blended to form a homogeneous blend.

The outer PVDF layer could also consist of an acrylic-modified fluoropolymer (AMF), as described in US 6,680,357. The use of a thin AMF layer provides an exceptionally clear PVDF layer.

In a preferred embodiment, the PVDF layer is a PVDF homopolymer. The PVDF homopolymer provides a high level of hardness and scratch resistance, and also provides an excellent balance between melting point and thermal decomposition, providing for ease of manufacture. It is also highly compatible with a PVDF/PMMA tie layer.

### Thermoplastic Glazing

Since the thin PVDF layer does not have the strength needed for the final application, it is directly or indirectly attached to a rigid transparent thermoplastic structural support layer. The thermoplastic glazing must be thick enough to support the glazing weight in the final application, and can vary with the type of thermoplastic, and the dimensions of the glazing, and the use in the final application . The transparent thermoplastic have to stand up to the higher temperature found on the inside of a solar collection device. Transparent thermoplastics useful in the present invention are limited to polycarbonate, polyester, polyethylene terphthalate, polystyrene, styrene/acrylonitrile copolymer, polyolefins, poly(vinyl chloride), chlorinated poly(vinyl chloride), imidized acrylic polymer, acrylic polymers, and their copolymers.

A preferred glazing material is an acrylic polymer. By "acrylic", as used herein, includes polymers, copolymers and terpolymers formed from alkyl methacrylate and alkyl acrylate monomers, and mixtures thereof. The alkyl methacrylate monomer is preferably methyl methacrylate, which may make up from 50 to 100 percent of the monomer mixture. 0 to 50 percent of other acrylate and methacrylate monomers or other ethylenically unsaturated monomers, included but not limited to, styrene, alpha methyl styrene, acrylonitrile, and crosslinkers may also be present in the monomer mixture. Other methacrylate and acrylate monomers useful in the monomer mixture include, but are not limited to, methyl acrylate, ethyl acrylate and ethyl methacrylate, butyl acrylate and butyl methacrylate, iso-octyl methacrylate and acrylate, lauryl acrylate and lauryl methacrylate, stearyl acrylate and stearyl methacrylate, isobornyl acrylate and methacrylate, methoxy ethyl acrylate and methacrylate, 2-ethoxy ethyl acrylate and methacrylate, dimethylamino ethyl acrylate and methacrylate monomers. Alkyl (meth) acrylic acids such as methyl acrylic acid and acrylic acid can be useful for the monomer mixture.

In one embodiment, the thermoplastic glazing material contains impact modifier at a level of from 1 - 60 weight percent, based on the total weight of the impact modified glazing. For a transparent glazing, it is important that any impact modifier, should be refractive index (RI) matched to the thermoplastic matrix. By refractive index matched is meant that the impact modifier and matrix have refractive indexes within 0.02 of each other, and preferably within 0.01.

Other additives, such as UV stabilizers, plasticizers, fillers, coloring agents, pigments, antioxidants, antistatic agents, surfactants, toner, refractive index matching additives, and dispersing aids may also be present at low levels in the thermoplastic. Any additives should be chosen and used at minimal levels, to avoid interference with the transmission of solar radiation through the glazing.

### Intermediate layers

PVDF has excellent chemical resistance and dirt shedding properties. Unfortunately, it does not adhere easily to most materials. While in a few select structures a PVDF layer may be directly attached to a thermoplastic layer, in most cases, one or more layers of other materials (tie layers, adhesive layers, etc.) are needed between the PVDF later and thermoplastic glazing layer. The intermediate layer(s) together generally have a thickness of from 15 to 125 microns, and preferably from 15 to 30 microns.

Some examples of structures in which direct attachment can be made include, but are not limited to: an outer layer of a PVDF/PMMA blend, and a thermoplastic support layer of a polymethyl methacrylate.

In most structures of the invention, one or more tie and/or adhesive layers are needed to form a good bond between the PVDF layer and the thermoplastic glazing layer. An important feature of any tie or adhesive layer is that the layer be transparent to solar radiation, especially in the visible spectrum. Tie layer must be weatherable, meaning it must not degrade or yellow which would inhibit light transmission. The tie or adhesive layer could be impact modified (RI matched), and could also contain other additives, such as UV stabilizers, plasticizers, fillers, coloring agents, pigments, antioxidants, antistatic agents, surfactants, toner, refractive index matching additives, and dispersing aids may also be present at low levels in the thermoplastic. Any additives should be chosen and used at minimal levels, to avoid interference with the transmission of solar radiation through the glazing.

Adhesives can be used directly between the PVDF layer and the thermoplastic glazing, or can be used between a tie layer and either the PVDF layer or the glazing layer, as known in the art.

Useful intermediate or tie layers useful in the invention include, but are not limited to, a functional PVDF such as a maleic anhydride grafted PVDF used as a tie layer between a PVDF and most thermoplastics; a polamide elastomer that is a block copolymer of a polyamide with either a polyether or polyester (LOTADER, Arkema Inc.); and a PVDF copolymer with a high level of copolymer, such as KYNARFLEX 2800 and 2850 (PVDF/hexafluoropropylene copolymers from Arkema Inc.).

In one preferred embodiment, the tie layer is a blend of PVDF and PMMA that can be used as a tie layer between the thin PVDF homopolymer or copolymer layer and a thermoplastic glazing, especially an acrylic thermoplastic, and most preferably a PMMA or PMMA copolymer. The amount of PVDF in the tie layer is in the range of from 10 to 90 volume percent, preferably from 30 to 70 volume percent. The amount of PMMA would be in the range of 10 to 90 volume percent and preferably from 30 to 70 volume percent. Best adhesion properties to both the thin PVDF layer and a PMMA glazing would be a 50/50 blend by volume, which is approximately a 30/70 PVDF/PMMA blend by weight. The PVDF/PMMA blend interlayer is useful for bonding the PVDF layer to many thermoplastics, such as acrylics, polycarbonate, and polyesters.

The PVDF/thermoplastic glazing composite, optionally with an intermediate layer can be formed in many different ways. In one embodiment the PVDF layer, thermoplastic substrate and optional intermediate layer(s) are all coextruded into a single composite sheet, which can then be shaped for the final application. Alternatively, the thin PVDF layer is coextruded with a tie layer or layers into a thin film. The PVDF/tie layer composite is the laminated (heat and/or pressure) onto the rigid thermoplastic glazing. Alternatively, a PVDF or PVDF/PMMA coating is applied directly onto a thermoplastic glazing material by means known in the art such as by spraying, brushing, rolling or otherwise coating from an aqueous emulsion, solvent solution, The coating can then be baked at low temperatures to provide an even, uniform PVDF or PVDF/PMMA coating.

Films of PVDF can also be obtained by a blown film process. These films can then be laminated or attached with adhesives to the thermoplastic glazing material.

Another means of forming the transparent glazing material is in an in-line or in-mold insert molding process, in which a film of PVDF or PVDF and a tie layer is placed in a mold, followed by an injection molding of the rigid thermoplastic. This process could be used to form a sheet, or any shaped article.

### Photovoltaic module

The composite thermoplastic glazing material having a PVDF outer layer can then be used as the glazing for photovoltaic modules, solar collectors, and other photovoltaic devices by means known in the art. The thermoplastic materials have advantages over glass, in terms of lower weight, better impact resistance, and ease in which they can be formed into different sizes and shapes.

In addition to finding use in photovoltaic modules, the PVDF coated rigid thermoplastic could also be useful anywhere a thermoplastic glazing is used, and where dirt shedding and chemical resistance are important. The invention is especially useful in cases where the PVDF thermoplastic is exposed to harsh environments, or is used in a position other than vertical. Such uses would include, for instance greenhouse glazing.

### EXAMPLES

### Example 1:

A thin film with a total thickness of about 50 microns is formed by the coextrusion of a Kynar 710 (PVDF from Arkema Inc.) with a second extrusion stream formed by a 30/70 wt% blend of PVDF/PMMA (Kynar 710 /Altuglas V920 both from Arkema Inc.). The composite film is then laminated onto a PMMA sheet (Altuglas V046L) though a hot lamination during the melt extrusion with the PVDF/PMMA blend intermediate between the PVDF layer and the PMMA layers. The PVDF film was laminated onto extruded PMMA sheets in a width of 11 inches, exhibiting excellent optical transparency up to 93.5%. The PVDF film laminated PMMA sheets passed the cross-hatch adhesion tests with no delamination as ranked at 5B (100%). Also, the PVDF film laminated PMMA sheets possessed better UV blocking performance as compared to that in extruded PMMA (V046L). The haze level was reduced to -10% with the 50 um two-layered film on the PMMA sheets, as compared to ∼20% in the film.

## Claims

1. A photovoltaic module, comprising a transparent glazing material comprising:
a) a thermoplastic layer; and
b) a polyvinylidene fluoride (PVDF) outer layer exposed to the environment; and attached directly or indirectly to said thermoplastic layer;
wherein said thermoplastic layer is selected from the group consisting of polycarbonate, polyester, polyethylene terphthalate, polystyrene, styrene/acrylonitrile copolymer, polyolefins, poly(vinyl chloride), chlorinated poly(vinyl chloride), imidized acrylic polymer, an acrylic polymer, and their copolymers and
wherein the outer polyvinylidene fluoride layer has a thickness of from 3 - 100 microns;
**characterized in that**
said thermoplastic layer is a rigid support layer.

2. The photovoltaic module of claim 1, further comprising one or more intermediate layers between the polyvinylidene fluoride layer and the rigid thermoplastic layer, wherein each layer is directly attached to the adjoining layer(s).

3. The photovoltaic module of claim 1 or 2, wherein the outer layer is a homopolymer of polyvinylidene fluoride.

4. The photovoltaic module of claim 1 or 2, wherein the outer layer is a copolymer or terpolymer of polyvinylidene fluoride.

5. The photovoltaic module of any one of claims 1 to 4, wherein the outer layer is a blend of polyvinylidene fluoride and polymethyl methacrylate.

6. The photovoltaic module of any one of claims 1 to 4, wherein the outer layer is an acrylic modified fluoropolymer.

7. The photovoltaic module of any one of claims 1 to 6, wherein the outer polyvinylidene fluoride layer has a thickness of from 15 to 50 microns.

8. The photovoltaic module of any one of claims 2 to 7, wherein one or more of the intermediate layers, and/or the rigid thermoplastic layer contains from 1 - 60 weight percent of impact modifiers based on the total weight of the layer, and wherein said impact modifiers are refractive index matched to the matrix of the layer they are in.

9. The photovoltaic module of any one of claims 2 to 4, comprising an intermediate layer that is a blend of polyvinylidene fluoride and polymethyl methacrylate (PMMA).

10. The photovoltaic module of claim 9, wherein the volume ratio of PVDF to PMMA is from 30/70 to 70/30.

## Patentansprüche

1. Photovoltaikmodul, umfassend ein transparentes Verglasungsmaterial, umfassend:
a) eine thermoplastische Schicht und
b) eine Polyvinylidenfluorid(PVDF)-Außenschicht, die der Umgebung ausgesetzt ist und direkt oder indirekt an der thermoplastischen Schicht angebracht ist;
wobei die thermoplastische Schicht aus der Gruppe bestehend aus Polycarbonat, Polyester, Polyethylenterephthalat, Polystyrol, Styrol/Acrylnitril-Copolymer, Polyolefinen, Poly(vinylchlorid), chloriertem Poly(vinylchlorid), imidiertem Acrylpolymer, einem Acrylpolymer und Copolymere davon ausgewählt ist und
wobei die Polyvinylidenfluorid-Außenschicht eine Dicke von 3-100 Mikron aufweist;
**dadurch gekennzeichnet, dass** es sich bei der thermoplastischen Schicht um eine steife Trägerschicht handelt.

2. Photovoltaikmodul nach Anspruch 1, ferner umfassend ein oder mehrere Zwischenschichten zwischen der Polyvinylidenfluorid-Schicht und der steifen thermoplastischen Schicht, wobei jede Schicht direkt an der angrenzenden Schicht bzw. den angrenzenden Schichten angebracht ist.

3. Photovoltaikmodul nach Anspruch 1 oder 2, wobei es sich bei der Außenschicht um ein Homopolymer von Polyvinylidenfluorid handelt.

4. Photovoltaikmodul nach Anspruch 1 oder 2, wobei es sich bei der Außenschicht um ein Copolymer oder Terpolymer von Polyvinylidenfluorid handelt.

5. Photovoltaikmodul nach einem der Ansprüche 1 bis 4, wobei es sich bei der Außenschicht um eine Mischung von Polyvinylidenfluorid und Polymethylmethacrylat handelt.

6. Photovoltaikmodul nach einem der Ansprüche 1 bis 4, wobei es sich bei der Außenschicht um ein acrylmodifiziertes Fluorpolymer handelt.

7. Photovoltaikmodul nach einem der Ansprüche 1 bis 6, wobei die Polyvinylidenfluorid-Außenschicht eine Dicke von 15 bis 50 Mikron aufweist.

8. Photovoltaikmodul nach einem der Ansprüche 2 bis 7, wobei eine oder mehrere der Zwischenschichten und/oder die steife thermoplastische Schicht 1-60 Gewichtsprozent Schlagzähigkeitsmodifikatoren, bezogen auf das Gesamtgewicht der Schicht, enthalten und wobei die Schlagzähigkeitsmodifikatoren an die Matrix der Schicht, in der sie sich befinden, brechungsindexangepasst sind.

9. Photovoltaikmodul nach einem der Ansprüche 2 bis 4, umfassend eine Zwischenschicht, bei der es sich um eine Mischung von Polyvinylidenfluorid und Polymethylmethacrylat (PMMA) handelt.

10. Photovoltaikmodul nach Anspruch 9, wobei das Volumenverhältnis von PVDF zu PMMA 30/70 bis 70/30 beträgt.

## Revendications

1. Module photovoltaïque, comprenant un matériau de vitrage transparent comprenant :
a) une couche thermoplastique ; et
b) une couche externe de poly(fluorure de vinylidène) (PVDF) exposée à l'environnement ; et directement ou indirectement fixée à ladite couche thermoplastique ;
dans lequel ladite couche thermoplastique est choisie dans le groupe constitué des polycarbonate, polyester, poly(téréphtalate d'éthylène), polystyrène, copolymère de styrène/acrylonitrile, polyoléfines, poly(chlorure de vinyle), poly(chlorure de vinyle) chloré, polymère acrylique imidisé, un polymère acrylique, et leurs copolymères et dans lequel la couche externe de poly(fluorure de vinylidène) a une épaisseur de 3 à 100 microns ;
**caractérisé en ce que**
ladite couche thermoplastique est une couche de support rigide.

2. Module photovoltaïque de la revendication 1, comprenant en outre une ou plusieurs couches intermédiaires entre la couche de poly(fluorure de vinylidène) et la couche thermoplastique rigide, dans lequel chaque couche est directement fixée à la ou les couche(s) adjacente(s).

3. Module photovoltaïque de la revendication 1 ou 2, dans lequel la couche externe est un homopolymère de poly(fluorure de vinylidène).

4. Module photovoltaïque de la revendication 1 ou 2, dans lequel la couche externe est un copolymère ou terpolymère de poly(fluorure de vinylidène).

5. Module photovoltaïque de l'une quelconque des revendications 1 à 4, dans lequel la couche externe est un mélange de poly(fluorure de vinylidène) et de poly(méthacrylate de méthyle).

6. Module photovoltaïque de l'une quelconque des revendications 1 à 4, dans lequel la couche externe est un fluoropolymère modifié par acrylique.

7. Module photovoltaïque de l'une quelconque des revendications 1 à 6, dans lequel la couche externe de poly(fluorure de vinylidène) a une épaisseur de 15 à 50 microns.

8. Module photovoltaïque de l'une quelconque des revendications 2 à 7, dans lequel une ou plusieurs des couches intermédiaires, et/ou la couche thermoplastique rigide contient de 1 à 60 pour cent en poids de modificateurs de résistance au choc sur la base du poids total de la couche, et dans lequel lesdits modificateurs de résistance au choc ont un indice de réfraction correspondant à la matrice de la couche dans laquelle ils se trouvent.

9. Module photovoltaïque de l'une quelconque des revendications 2 à 4, comprenant une couche intermédiaire qui est un mélange de poly(fluorure de vinylidène) et de poly(méthacrylate de méthyle) (PMMA).

10. Module photovoltaïque de la revendication 9, dans lequel le rapport en volume de PVDF à PMMA est de 30/70 à 70/30.
